# EUROPEAN PATENT SPECIFICATION

(11) **EP 3 918 104 B1**
(45) Date of publication and mention of the grant of the patent: **01.11.2023**
(21) Application number: 20701794.8
(22) Date of filing: 30.01.2020
(51) Int. Cl.: C23C 2/06, C23C 14/06, C23C 16/26, C23C 16/27

(54) **USE OF A DLC COATED PART IN A GALVANIZING BATH**
VERWENDUNG EINES DLC-BESCHICHTETEN TEILES IN EINEM VERZINKUNGSBAD
UTILISATION D'UNE PIÈCE REVÊTUE DE DLC DANS UN BAIN DE GALVANISATION

(30) Priority: 01.02.2019 EP 19290009
(43) Date of publication of application: 08.12.2021
(73) Proprietor: Primetals Technologies Austria GmbH, 4031 Linz (AT)
(72) Inventor: JAX, Klaus, 4202 Hellmonsödt (AT); GRENIER, Benjamin, 42740 Saint-Paul-En-Jarez (FR)
(74) Representative: Metals@Linz
(86) International application number: PCT/EP2020/052291
(87) International publication number: WO 2020/157198

(56) References cited:
- EP-A1- 0 919 638
- WO-A1-00/31311
- WO-A1-2015/183565
- US-A1- 2008 274 006
- US-A1- 2014 173 995
- US-A1- 2019 172 714

## Description

Use of a coated part in a galvanizing bath, being submerged into the galvanizing bath and put in contact with a hot metal liquid.

The present invention is based on a use of coating parts according to the appended claims.

Today some methods are known as method for coating at least one part of a device/piece which is foreseen to be submerged within a galvanizing bath and put in contact with a hot metal liquid within said bath, wherein said part is coated mainly by means of a coating comprising Si-Al-Nitride (sialon^{®}), Stellite (Co, Cr, W, Mo, C), Tungsten carbide or Ceramics based material. The part (to be coated) is mainly made in a cobalt based steel, a carbon steel or even in a stainless steel.

None of these coatings from the state-of-the-art for galvanizing applications are able to be fully appropriated against all of the following three kinds of conditions:
- high temperature (430°C up to 700°C),
- wear or abrasive conditions (tension stress, especially by moving parts in the bath or between parts in friction in the bath),
- hot corrosion in a metal liquid (poor non-adhesion property).

The following table illustrates the weak points for each of these coatings from the state-of-the-art for galvanizing applications:

| **Coating** | **Temperature** | **Wear** | **Hot Corrosion** |
|---|---|---|---|
| Si-Al-Nitride | 400-700°C | Not satisfying | Satisfying |
| Stellite | Not satisfying | Not satisfying | Not satisfying |
| Tungsten carbide | 400-700°C | Satisfying | Not satisfying |
| Ceramics | 400-700°C | Not satisfying | Satisfying |

Especially a further drawback for Stellite and Ceramics is due to their expensive price.

EP 0 919 638 B1 discloses a molten metal resistant tungsten carbide containing overlay for use on journals, sleeves, and bushings on submerged rolls in hot dip molten metal baths provided by laser melting techniques.

US 2008/274006 A1 discloses coated industrial parts for use in molten metal baths comprising of a steel alloy core material and a metallurgically bonded surface cladding of various compositions.

One goal of the invention is to provide a use of a coated part in a galvanizing bath, being submerged into the galvanizing bath and put in contact with a hot metal liquid wherein the coating is realized by a vapor deposition step comprising Diamond-Like-Carbon, wherein the coating shall resist strongly to all three conditions and their stress:
- high temperature conditions, e.g. over 430°C and up to 700°C,
- wear or abrasive conditions of parts in the bath;
- hot corrosion effects between coating and the hot metal liquid in the bath (like zinc, aluminum, Magnesium, etc.).

Said hot corrosion effects are furthermore leading to problems of adhesion properties of the metal liquid on the coating. Due to this problem it is very difficult to clean the part by a maintenance session.

The coating method should also be economically better than present coatings like Stellite or Ceramics.

A use of coated part according to the invention is hence proposed over claim 1.

At least one part of a device or a piece which is foreseen to be submerged within a galvanizing bath and put in contact with a hot metal liquid within said bath, the coating is realized by a vapor deposition step comprising Diamond-Like-Carbon. Such a coating will be depicted as DLC-coating in the following text.

One first advantage of the present use of a coated part providing a DLC-coating relies in a very high resistance of the coated part against temperature from 430°C up to 700°C of a typical hot metal liquid in the galvanizing bath.

A second advantage of the method relies in that the DLC-coating can be realized to obtain a resistance against stress for at least one of the following stress:
- for a tension up to 60kN;
- if the part is rotating for a rotation speed up to 10 m/s.

These ranges of values are very satisfying the requirements of a galvanizing application.

A third advantage of the use of a coated part relies in that the DLC-coating can be realized to resist to hot corrosion between the coating and the hot metal liquid, especially by a range of temperature between 430°C up to 700°C from the hot metal liquid in the galvanizing bath.

Compared to all known coatings of the prior arts, DLC-coating are hence a solution which satisfy all three major conditions by a galvanizing application as defined by the goal of the invention.

DLC-coating which are provided by vapor deposition are also much cheaper than Stellite or Ceramics based coatings. A recent analysis at a continuous galvanizing line of a Primetals client shows that some client's cost of more than 2,5 million EUR per year can be saved for spare parts and their maintenance if these spare parts were coated according to the present method of the invention.

The experience also showed that the method according to the invention can be much improved to ensure the fulfilling of these three conditions if the DLC-coating is provided as a Si doped coating composed as a C:H:Si
(Carbon:Hydrogen:Silicium), optionally in a multi-layer form, and especially applied with a suitable PACVD process (Plasma Assisted Chemical Vapor Deposition). This coating shows especially a very low friction coefficient at atmospheric condition of about 0,05 to 0,1 for coating thickness range from just a few µm up to 60um and shows a hardness value from 1500 to 2500 HV and above. This type of DLC coating shows also quite high thermal stability (up to 700°C) thanks to the Si-doped coating layer structure and is not reacting with the hot metal liquid like zinc (amorphous structure, chemical inert).

The present use of a coating according to the invention is also applied for many kind of parts with diverse materials because DLC-coatings are suitable for coating with high adherence on many steel based materials. Due to this point, it is hence possible to use some cheaper based material for the part itself, e.g. it is not obliged to systematically use stainless steel or even more expensive metals. Mainly the submerged part is foreseen as a roll, a pipe, a supporting arm, a snout bottom part, a pump, tools for removing dross, measurement devices or a bearing.

## Claims

1. Use of a coated part in a galvanizing bath, being submerged into the galvanizing bath and put in contact with a hot metal liquid wherein the coating is realized by a vapor deposition step comprising Diamond-Like-Carbon.

2. Use according to any previous claims wherein the coating is a Si-doped coating composed as C:H:Si, optionally in a multi-layer form.

3. Use according to Claim 2, wherein the coating is applied with a suitable PACVD process (Plasma Assisted Chemical Vapor Deposition).

4. Use according to any previous claims, wherein the submerged part is a roll, a pipe, a supporting arm, a snout bottom part, a pump, tools for removing dross, measurement devices or a bearing.

## Patentansprüche

1. Verwendung eines beschichteten Teils in einem Galvanisierbad in das Galvanisierbad eingetaucht und in Kontakt mit einer heißen Metallflüssigkeit gebracht, wobei die Beschichtung durch einen Gasphasenabscheidungsschritt, umfassend diamantartigen Kohlenstoff, ausgeführt ist.

2. Verwendung gemäß einem der vorstehenden Ansprüche, wobei die Beschichtung eine Si-dotierte Beschichtung, zusammengesetzt als C:H:Si, gegebenenfalls in einer mehrschichtiger Form, ist.

3. Verwendung gemäß Anspruch 2, wobei die Beschichtung durch ein geeignetes PACVD-Verfahren (plasmaunterstützte chemische Gasphasenabscheidung) aufgebracht ist.

4. Verwendung gemäß einem der vorstehenden Ansprüche, wobei der eingetauchte Teil eine Walze, ein Rohr, ein Trägerarm, ein unteres Mundstückteil, eine Pumpe, Werkzeuge zum Entfernen von Schlacke, Messvorrichtungen oder ein Lager ist.

## Revendications

1. Utilisation d'une pièce revêtue dans un bain de galvanisation, qui est immergée dans le bain de galvanisation et qui est mise en contact avec un métal liquide chaud, dans laquelle le revêtement est réalisé par une étape de dépôt en phase vapeur qui comprend du carbone sous forme de diamant amorphe (diamond-like carbon).

2. Utilisation selon l'une quelconque des revendications précédentes, dans laquelle le revêtement est un revêtement dopé au silicium, composé de C:H:Si, de manière facultative sous une forme multicouche.

3. Utilisation selon la revendication 2, dans laquelle le revêtement est appliqué avec un procédé PAVCD (dépôt chimique en phase vapeur assisté par plasma) approprié.

4. Utilisation selon l'une quelconque des revendications précédentes, dans laquelle la pièce immergée est un rouleau, un tuyau, un bras de support, une partie inférieure d'une busette de coulée, une pompe, des outils destinés à l'élimination des scories, des dispositifs de mesure ou un palier.
